(19) Europäisches Patentamt
European Patent Office
Office européen des brevets

(11) **EP 2 924 485 B1**

(12) **EUROPEAN PATENT SPECIFICATION**

(45) Date of publication and mention
of the grant of the patent:
**01.03.2023 Bulletin 2023/09**

(21) Application number: **15158672.4**

(22) Date of filing: **11.03.2015**

(51) International Patent Classification (IPC):
*G02B 7/182* (2006.01)     *G02B 26/08* (2006.01)
*G02B 26/10* (2006.01)     *H01L 41/09* (2006.01)

(52) Cooperative Patent Classification (CPC):
**H01L 41/0953; G02B 26/0858; G02B 26/101;**
G02B 7/1821

(54) **Optical deflection device, and image display device**

Optische Ablenkeinrichtung und Bildanzeigevorrichtung

Dispositif de déflexion optique et dispositif d'affichage d'image

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.03.2014 JP 2014050337**

(43) Date of publication of application:
**30.09.2015 Bulletin 2015/40**

(73) Proprietor: **Ricoh Company, Ltd.**
**Tokyo 143-8555 (JP)**

(72) Inventors:
• **Shinkawa, Mizuki**
**Tokyo 143-8555 (JP)**
• **Hasiguchi, Tsuyoshi**
**Tokyo 143-8555 (JP)**

(74) Representative: **J A Kemp LLP**
**80 Turnmill Street**
**London EC1M 5QU (GB)**

(56) References cited:
EP-A1- 2 495 600    EP-A1- 2 645 148
EP-A1- 2 848 978    US-A1- 2004 263 937

## Description

BACKGROUND OF THE INVENTION

Field of the Invention

The present invention relates to the configuration of optical deflection mirrors, optical deflection devices and image display devices each employing the optical deflection mirrors.

Description of the Related Art

In recent years, to achieve size reduction and cost reduction of optical deflection devices and image display devices each provided with optical deflection mirrors, the optical deflection mirrors are fabricated through micro machining to which semiconductor fabrication technique is applied.

The optical deflection mirror, which deflects and scans a light beam, is fabricated as a micro electro mechanical systems (MEMS) device through fine processing silicon or glasses, for example, by integrally forming a movable portion provided with a reflective surface and elastic beam-shaped members on a substrate.

Further, piezoelectric actuator systems may be used as mirror driving systems for such optical deflection mirrors, which are provided with thin-film piezoelectric materials laminated on the elastic beam-shaped members.

Due to its piezoelectric characteristics, the piezoelectric actuator systems transmit expansions and contractions of the piezoelectric materials to a supporting member forming a cantilever, thus oscillating the cantilever to rotate the mirror.

Further, on the same plane orthogonal to the optical axis of the light beam, this mirror is rotated about two axes as center axes, which are a first axis (in a horizontal direction) and a second axis (in a vertical direction) orthogonal to each other, thereby enabling two-dimensional scanning.

On the other hand, in performing two-dimensional light scanning with the optical deflection device using the optical deflection mirror, in general, resonance driving with mechanical resonance frequencies is used for light scanning in the horizontal direction, while non-resonance driving is used for light scanning in the vertical direction.

For example, for the resonance driving in the horizontal scanning, the cantilever is secured at its one end to a frame portion to be supported thereby, while the cantilever is oscillated at its other end through piezoelectric driving. The oscillations of the cantilever generate torques, which are transmitted to a torsion bar (elastic beam-shaped member) which is coupled to the other end of the cantilever, thereby rotating and driving the mirror installed at the tip end of the torsion bar. This provides a larger scanning angle through driving at lower voltages.

On the other hand, the non-resonance driving in the vertical direction is used, since there is a need for raster scanning, in order to attain higher fineness and in-surface uniformization, in cases where it is applied to an image display device and the like, for example.

In general, sawtooth waves are used as driving signals, for performing raster scanning. However, oscillation components of resonance, which are determined by the weight of the movable portion, the rigidity of the cantilever and the like, may interfere with higher harmonics for this driving.

Such interference of oscillation components of resonance during light scanning may cause brightness unevenness, image distortions and the like to degrade the image quality of displayed images. Accordingly, it is necessary to adjust the amplitude and the phase of the applied driving signal for suppressing oscillations caused by resonance.

However, if environmental changes including a change in ambient temperature around the optical deflection device are induced, this also changes resonance characteristics in the sub-scanning direction, along with the changes of the piezoelectric characteristics and the physical values of the optical deflection mirror configuration. As a result, the driving signal having been adjusted in such a way as to suppress the interference in the light scanning with respect to the room temperature may be made inappropriate.

This appears as time-varying brightness unevenness and image distortions in the displayed images during raster scanning, which causes degradations and instability in image quality depending on the environmental temperature.

In view of this, there have been suggested techniques for ensuring uniformity of the scanning speed during raster scanning (refer to JP-2011-107505-A).

In general, in cases of light scanning in two axes, during light scanning in the vertical direction, a waving phenomenon occurs due to interference between higher harmonics for non-resonance driving and a resonance frequency caused by the configuration for scanning in the vertical direction. This makes the scanning non-uniform.

According to JP-2011-107505-A, there is provided a speed detection means for detecting the speed of light scanning, and the speed is fed back to a scanning driving means based on these speed detection signals, for reducing the non-uniformity of the scanning speed of light scanning.

However, this structure necessitates an additional sensor mechanism for detecting light-scanning speed signals, which complicates the entire device structure and, also, induces the problem of obstruction of the size reduction in the entire device.

Further, due to light scanning in the two axes, it is impossible to avoid mixture of signals in the horizontal direction and in the vertical direction, which causes the problem of burdens imposed on processing for avoiding the mixture of signals and, further, causes the problem of significant difficulty of completely eliminating such mixture.

Further, in cases of further coping with the change of the environmental temperature, it is necessary to consider the temperature dependency of the entire device including the sensor mechanism and, also, it is necessary to optimize the respective mechanisms and conditions for performing feedback control, which increases the cost for fabrication such as development cost.

EP 2 495 600 A1 and EP 2 645 148 A1 disclose drivers for optical deflectors using complex-sinusoidal-wave drive voltages and methods for setting the same.

EP 2 848 978 A1 discloses an optical deflection device, apparatus including the same, and a method of controlling the optical deflection device.

According to the present invention, there is provided a method of configuring an optical deflection device and a method of fabricating a image projection device as defined in any one of the accompanying claims.

SUMMARY OF THE INVENTION

One of the objectives of at least one embodiment of the present invention is to overcome the aforementioned conventional problems in controlling driving signals for light scanning in the vertical direction for axial raster scanning, thus reducing the non-uniformity of the scanning speed. Further, for an optical deflection device and an image display device using the same optical deflection device, the present invention aims at providing an optical deflection device capable of ensuring scanning uniformity regardless of the ambient environmental temperature with a simple structure. This suppresses the occurrence of brightness unevenness and image distortions for providing images with higher quality.

Example embodiments of the present invention include a method of configuring an optical deflection device according to the independent claim.

Further example embodiments of the present invention are included in the dependent claims.

With this configuration, scanning uniformity is ensured regardless of the ambient environmental temperature, with a simple structure. This further suppresses the occurrence of brightness unevenness and image distortions for providing images with higher quality.

BRIEF DESCRIPTION OF THE SEVERAL VIEWS OF THE DRAWINGS

A more complete appreciation of the disclosure and many of the attendant advantages and features thereof can be readily obtained and understood from the following detailed description with reference to the accompanying drawings, wherein:

Fig. 1 is a front view of an optical deflection mirror which is applied to an optical deflection device that is used in a method of the present invention;

Fig. 2 is a block diagram illustrating a structure a two-dimensional image display device using the optical deflection device that is used in a method of the present invention;

Figs. 3A and 3B illustrate the optical deflection device that is used in a method of the present invention, Fig. 3A is an explanation view of raster scanning, and Fig. 3B is a graphic view of reciprocating scanning deviations induced during raster scanning;

Figs. 4A to 4D are graphic views of examples of driving signals for the optical deflection mirror in the optical deflection device that is used in a method of the present invention;

Figs. 5A and 5B illustrate the optical deflection device that is used in a method of the present invention, Fig. 5A is a graphic view of ideal raster scanning, and Fig. 5B is a graphic view of a state where speed waving has occurred in a case where a mechanical resonance component interferes with non-resonance driving;

Fig. 6 is a graphic view of a specific frequency characteristic in mechanical resonance modes in the vertical direction of the optical deflection mirror in the optical deflection device that is used in a method of the present invention;

Fig. 7 is a graphic view of frequency components resulted from an FFT analysis performed on frequency components of a mirror driving signal;

Fig. 8 is a graphic diagram illustrating overlapping between mechanical resonance and frequency components of driving signals;

Fig. 9 is a graphic diagram of a resonance frequency characteristic of a linear temperature coefficient;

Fig. 10 is a graphic diagram illustrating the relative relationship between the resonance frequency and the driving frequency of the optical deflection mirror;

Fig. 11 is a graphic view for illustrating (temperature) the temperature dependency of image light-intensity unevenness in two-dimensional image display using the optical deflection device that is used in a method of the present invention; and

Fig. 12 is a graphic view for illustrating (vertical axis Y) the temperature dependency of the image light-intensity unevenness in two-dimensional image display using the optical deflection device that is used in a method of the present invention.

The accompanying drawings are intended to depict example embodiments of the present invention and should not be interpreted to limit the scope thereof. The accompanying drawings are not to be considered as drawn to scale unless explicitly noted.

DETAILED DESCRIPTION OF THE INVENTION

The terminology used herein is for the purpose of describing particular embodiments only and is not intended to be limiting of the present invention. As used herein, the singular forms "a", "an" and "the" are intended to include the plural forms as well, unless the context clearly indicates otherwise. It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

In describing example embodiments shown in the drawings, specific terminology is employed for the sake of clarity. However, the present disclosure is not intended to be limited to the specific terminology so selected and it is to be understood that each specific element includes all technical equivalents that operate in a similar manner.

Hereinafter, there will be described an optical deflection mirror that is used in a method of the present invention.

The optical deflection mirror in an optical deflection device for performing light scanning through non-resonance driving is structured to have cantilevers provided with piezoelectric materials in a mender shape. Out of these cantilevers, different voltages are applied to every other cantilevers for causing warpage in the respective cantilevers, thus rotating a reflective surface for light scanning.

In this case, the voltages applied to every other cantilevers are sawtooth waves having such a pattern that a rising time period and a falling time period in a single period are alternately interchanged. Their relative phases and their maximum voltage values are adjusted, thereby reducing the waving of the scanning speed due to mechanical resonance.

However, in cases where physical constants of the members are changed along with the ambient environmental temperature, and the resonance frequency derived from the configuration is changed, oscillations of mechanical resonance may be enhanced by the non-resonance driving, which may change the uniformity of the light scanning speed in the vertical direction. This has induced variations and degradations in image qualities, in some cases.

In view of this, in the present invention, for an assumed environmental temperature range for the optical deflection mirror, the optical deflection device and the image projection device, and for variations of the resonance frequency of the optical deflection mirror at that time, the relative value of the frequency of the driving signal applied to every other cantilever with respect to the resonance frequency is continuously deviated from an integer-multiple relationship. This improves the uniformity of the light scanning speed of the mirror, thereby realizing sufficient linearity regardless of the temperature.

Meander-shaped cantilevers are coupled and connected to the optical deflection mirror for use in the present invention. This device structure is designed in such a way as to ensure symmetry for safe operations, but it is impossible to make it have a completely symmetric shape due to characteristics of the meander-shaped pattern.

In this case, if there is such an integer-multiple relative relationship between the resonance frequency and the driving frequency, oscillation components caused by resonance are enhanced by operation components of the reflection mirror, and the resonance interferes with the higher harmonics for light scanning, which induces a waving phenomenon, thereby degrading the scanning uniformity.

Therefore, for assumed temperature variations and for the range within which the resonance frequency varies, the driving signal is adjusted such that the relative value of the frequency of the applied driving signal with respect to the resonance frequency is continuously deviated from an integer-multiple relationship. This suppresses the interference of oscillations caused by mechanical resonance with the light scanning through the non-resonance driving.

With the mechanism for adjusting the driving signal, it is possible to form images with higher quality and with excellent speed uniformity.

With the adjusted driving signal, images can be uniform over a wider temperature range such that it is not necessary to have a detection device such as a new temperature sensor.

Further, it is possible to provide uniform images, in a state where there is no need for performing complicated signal processing.

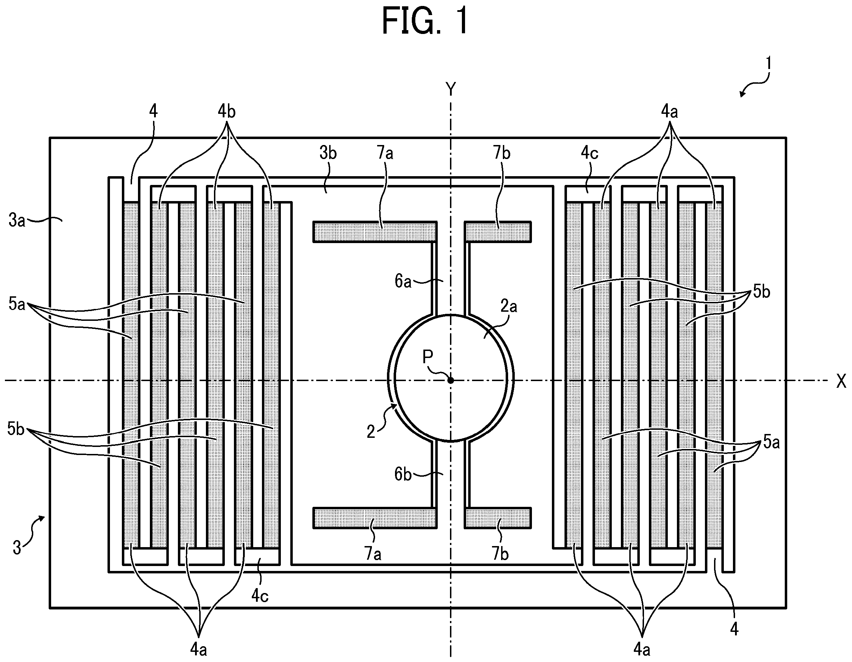

Hereinafter, the optical deflection device that is used in a method of the present invention will be described in detail, with reference to the drawings. At first, with reference to Fig. 1, there will be described the structure of a deflection mirror adapted to deflect and scan a light beam according to the embodiment of the present invention.

An optical deflection mirror 1 has respective members which have been formed integrally through an MEMS process, which will be described later. Further, the optical deflection mirror 1 includes a frame member 3 in which there is placed, at an approximate center thereof, a mirror 2 with a laser-light reflective surface 2a over its surface.

The mirror 2 is rotatable about two axes as center axes (a horizontal axis X and a vertical axis Y), which are orthogonal to each other in the same plane orthogonal to an optical axis P of laser light, to display two-dimensional images.

The frame member 3 supports a pair of meander-shaped beam portions 4 which are supported by an outer frame 3a at their respective one ends and are supported by a movable frame 3b at their respective other ends.

The pair of the meander-shaped beam portions 4 each includes longitudinal beam portions 4a and 4b, which are extended long along the vertical axis Y. The upper ends and lower ends of the beam portions 4a and 4b are alternately connected to each other at lateral beam portions 4c extending shortly along the horizontal axis X, which serve as folding-back sections. With this configuration, the pair of the meander-shaped beam portions 4 are formed to meander. Thus, the meander-shaped beam portions 4 are alternately divided into the longitudinal beam portions 4a and the longitudinal beam portions 4b, at their portions along the vertical axis Y except the lateral beam portions 4c. These respective longitudinal beam portions 4a and 4b adjacent to each other, which are meandered, are provided with independent piezoelectric members (piezoelectric member layers) 5a and 5b.

The movable frame 3b has a pair of torsion bars 6a and 6b extending on the same axis as the vertical axis Y above and below the mirror 2, and driving beams 7a and 7b having piezoelectric materials laminated thereon.

Light scanning in the vertical direction of the mirror 2 about the horizontal axis X is performed as follows. The respective piezoelectric members 5a and 5b are applied with different voltage waveforms to generate warpage (deformation) in the meander-shaped beam portions 4 for deflecting the longitudinal beam portions 4a and 4b adjacent to each other in the opposite directions. This is accumulated for rotating and driving the mirror 2 about the horizontal axis X in a non-resonance manner, thereby causing the optical deflection mirror 1 to play the function of a piezoelectric-type optical deflection mirror.

On the other hand, scanning in the horizontal direction of the mirror 2 about the vertical axis Y is performed through resonance driving using the driving beams 7a and 7b and the torsion bars 6a and 6b provided in the opposite sides beside the mirror 2.

With this structure, it is possible to perform light scanning, at the same time, in the directions of the two axes which are the horizontal axis X and the vertical axis Y.

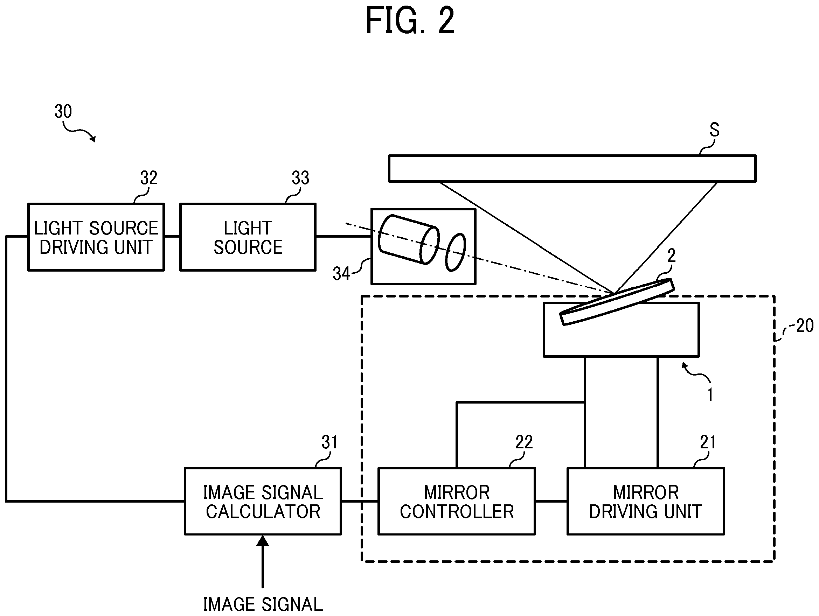

Next, with reference to Fig. 2, there will be described the structures of an optical deflection device 20 for driving the optical deflection mirror 1 illustrated in Fig. 1, and a two-dimensional image display device 30 including this optical deflection device 20.

The optical deflection device 20 includes the optical deflection mirror 1 having the mirror 2, a mirror driving unit 21, and a mirror controller 22.

The mirror controller 22 is implemented by a processor such as a microprocessor, and a memory such as a volatile or nonvolatile memory.

In the two-dimensional image display device 30, an image signal calculator 31 determines a laser light-emission intensity and launching timing based on image signals inputted thereto from the outside and, further, outputs control signals to a light source driving unit 32. The light source driving unit 32 controls the light emission from a light source 33, based on these control signals.

The light source 33 outputs a light beam, which irradiates the mirror 2 in the optical deflection mirror 1 through a beam optical system 34, so that images resulted from scanning by the optical deflection device 20 are projected as two-dimensional images onto a projection surface S.

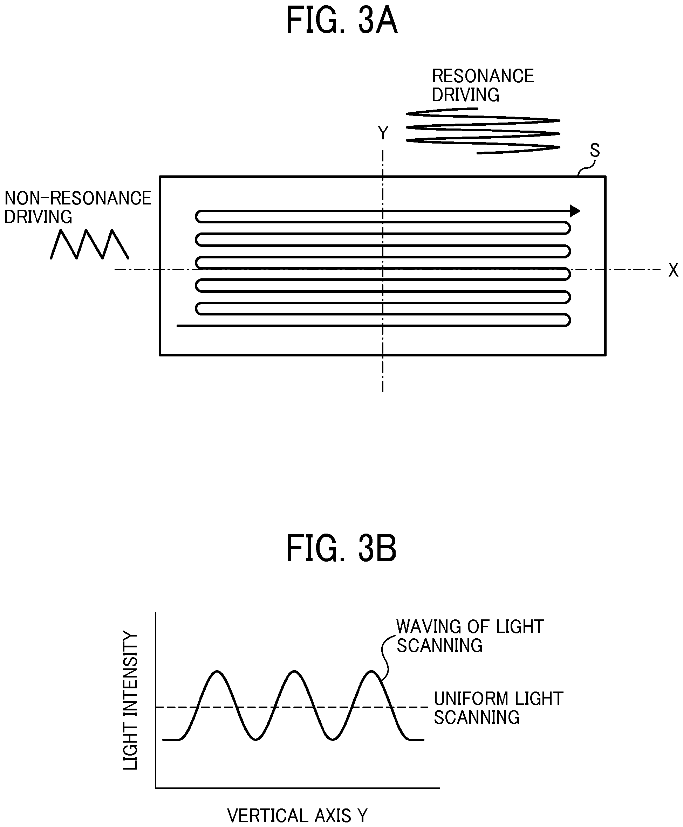

In this case, the optical deflection device 20 performs two-dimensional raster scanning, as illustrated in Fig. 3A, in order to project an appropriate image based on the image signals inputted from the outside, onto the projection surface S. Further, in Fig. 3A, the horizontal scanning in the direction of the horizontal axis X corresponds to mechanical resonance driving of the optical deflection mirror 1, while the vertical scanning in the direction of the Y axis corresponds to non-resonance driving of the optical deflection mirror 1.

In this case, in the vertical scanning direction, similarly, due to the weights, rigidities and the like of the respective members including the optical deflection mirror 1, and the like, there exists a specific resonance frequency, which may interfere with the oscillations of the non-resonance driving. This may cause an appearance of light intensity waving in the Y-axis direction, namely image intensity unevenness, as illustrated in Fig. 3B.

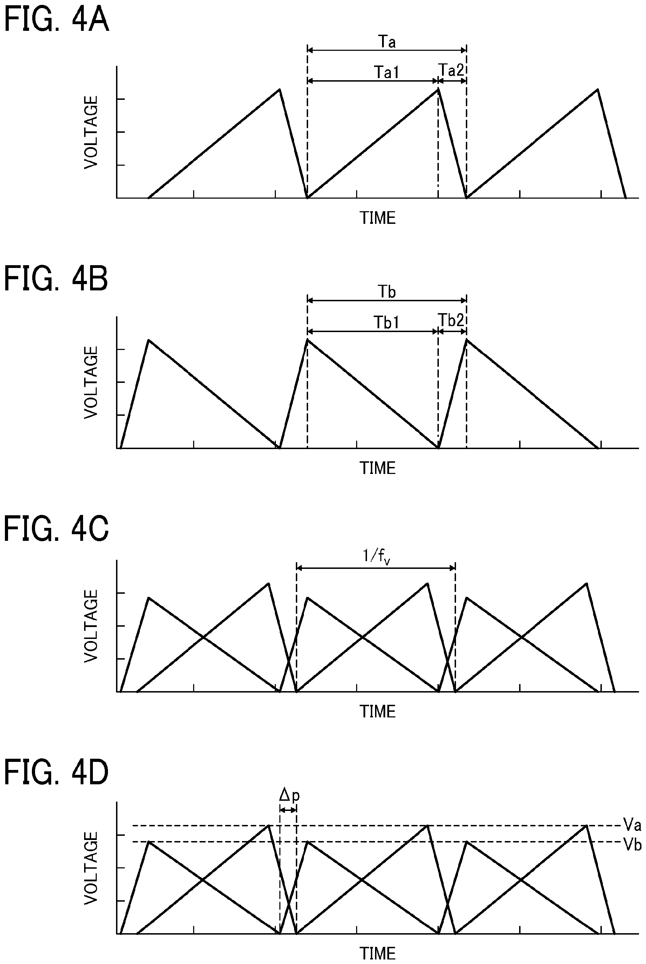

Hereinafter, with reference to Figs. 4A to 4D, a non-resonance driving method for the optical deflection mirror 1 will be described. In the following description, it will be assumed that voltage waveforms are applied to the longitudinal beam portions 4a and the longitudinal beam portions 4b, for convenience of description, although they are applied to the piezoelectric members 5a and 5b, in actual.

The patterns of the voltage waveforms applied to the meander-shaped beam portions 4 in the optical deflection mirror 1 are divided into the voltage signals applied to the longitudinal beam portions 4a and the voltage signals applied to the longitudinal beam portions 4b, as in Fig. 4A.

The patterns of the voltage waveforms have sawtooth waveforms, and a single period for the vertical scanning direction is divided into an interval within which the applied voltage is gradually changed for raster scanning, and an interval within which the applied voltage is abruptly changed for restoration.

More specifically, regarding the voltage applied to the longitudinal beam portions 4a, the time period Ta of a single period is divided into a time period Ta for raster scanning, and a time period Ta2 for restoration. In this case, assuming that the ratio of the time period for raster scanning to the time period of a single period is a symmetry Sa, there is held $Sa=Ta1/Ta$.

Similarly, regarding the voltage applied to the longitudinal beam portions 4b, with respect to the time period Tb of a single period, there is held $Sb=Tb1/Tb$. Further, with the driving frequency fv of the applied-voltage signal having the waveform, the time period of a single period can be expressed as $1/fv$, as illustrated in Fig. 4B. Further, this adjustment, which is referred to as individual adjustment of the driving frequency, is performed by the mirror driving unit 21 under control of the mirror controller 22.

On the other hand, in order to suppress the image unevenness illustrated in Fig. 3B, it is necessary to determine the uniformity of the light scanning speed in the vertical direction, and it is necessary to set signals for most improving the uniformity.

As setting parameters, as illustrated in Fig. 4D, there are listed the phase difference $\Delta p$ between the signals to the longitudinal beam portions 4a and the longitudinal beam portions 4b, and the maximum voltage values Va and Vb of the respective signals to the longitudinal beam portions 4a and the longitudinal beam portions 4b.

The mirror controller 22 stores a value for most improving the light scanning in the vertical direction in its memory and controls the driving of the mirror driving unit 21.

In this case, this adjustment is effective in the uniformity of light scanning, since the configuration of the meander-shaped beam portions 4 having the meander shape is not completely symmetric, in cases of driving in the vertical direction with the configuration of the optical deflection mirror 1.

Therefore, by compensating for the slight asymmetry through the adjustment of the values of the voltages to the longitudinal beam portions 4a and the longitudinal beam portions 4b, it is possible to suppress the induction of mechanical resonance.

However, with only this method, it is impossible to sufficiently suppress the variation of the light scanning speed along with the variation of the mechanical resonance frequency, which follows the change in ambient temperature around the optical deflection mirror 1.

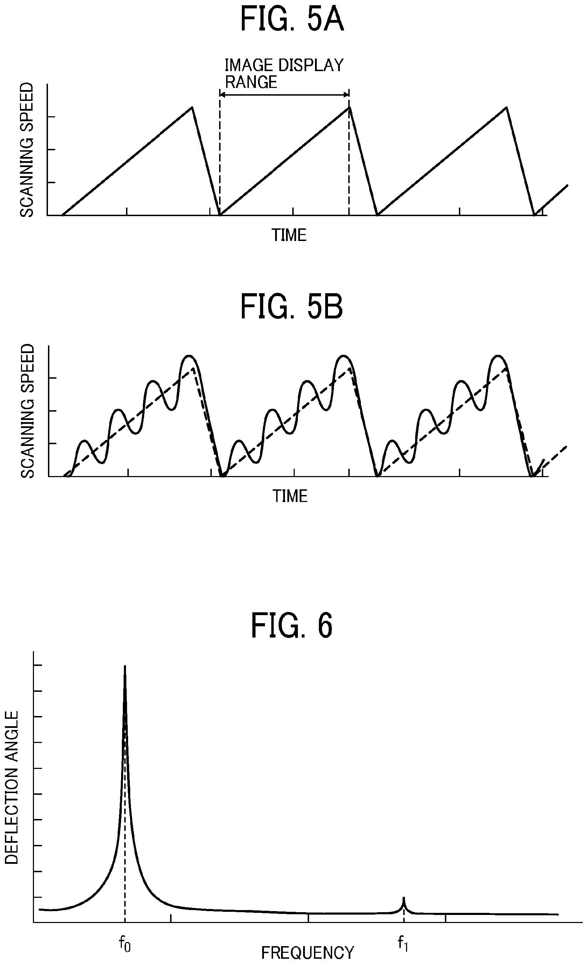

Fig. 5A illustrates a state where the light scanning speed within the image display range is ideally uniform, and Fig. 5B illustrates a state where speed waving has occurred in a case where a mechanical resonance component interferes with non-resonance driving.

The period of this waving is 1/f0, with respect to the mechanical resonance frequency f0 in the vertical direction of the optical deflection mirror 1.

Namely, as the relative relationship fv/f0 between the resonance frequency and the non-resonance driving is closer to an integer multiple, waving is more prone to be induced. In this case, the specific frequency characteristics in mechanical resonance modes in the vertical direction are as illustrated in Fig. 6 and have two or more resonance frequencies f1, in addition to the resonance frequency f0.

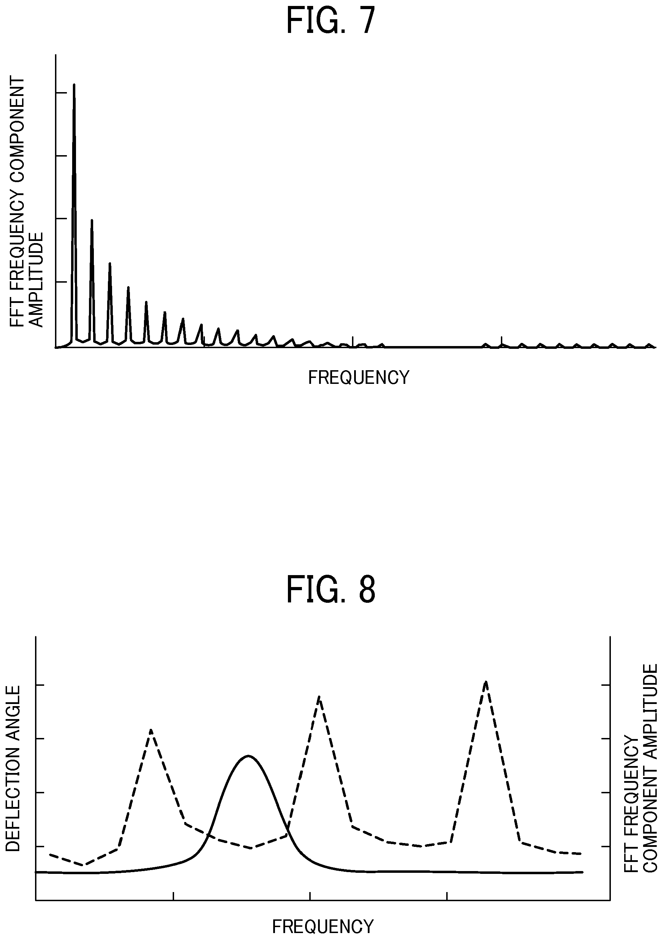

As a result thereof, a voltage signal having a sawtooth waveform illustrated in Figs. 4A to 4D also have a frequency component corresponding to the driving frequency fv. By performing an FFT analysis thereon, it is possible to recognize frequency components as illustrated in Fig. 7.

Therefore, as illustrated in Fig. 8, there is a need for taking account of the overlap between the mechanical resonance and the frequency components of the driving signal. In this case, the specific frequencies in mechanical resonance modes as illustrated in Fig. 6 have temperature dependency, due to the changes of the physical properties of the members and the performance of the thin-film materials in the piezoelectric members 5a and 5b, along with the temperature change in the usage environment.

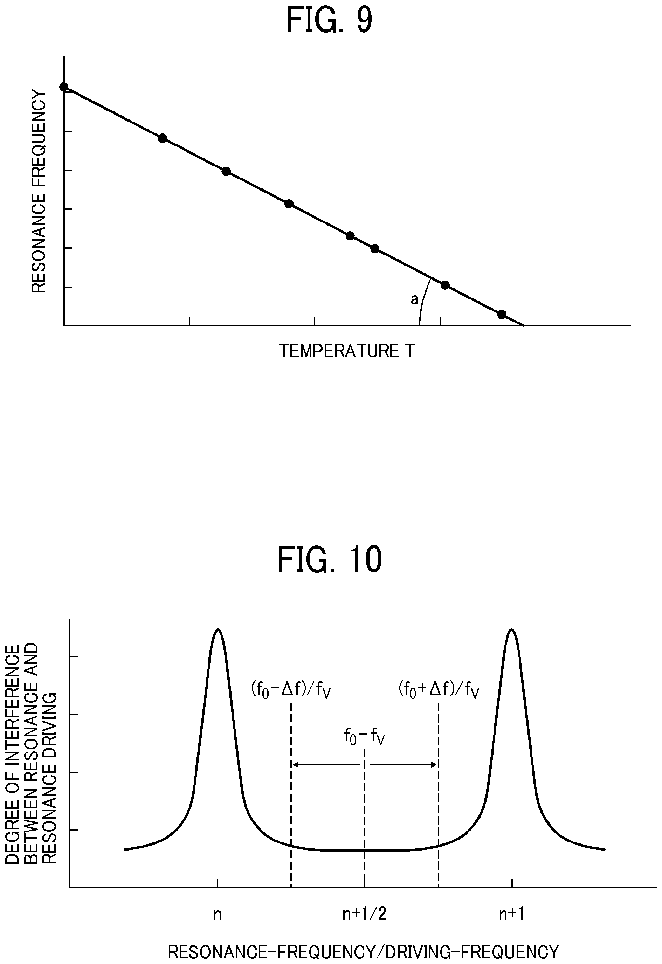

For addressing this, the optical deflection mirror 1 has a resonance frequency characteristic having a linear temperature coefficient as illustrated in Fig. 9, and this temperature gradient is assumed to be "a". Further, assuming that the temperature change around the optical deflection mirror 1 is $\Delta T$, and the shift of the resonance frequency is $\Delta f$, it is possible to express the relationship therebetween, as follows.

$$\Delta f = a \Delta T \qquad \text{(Equation 1).}$$

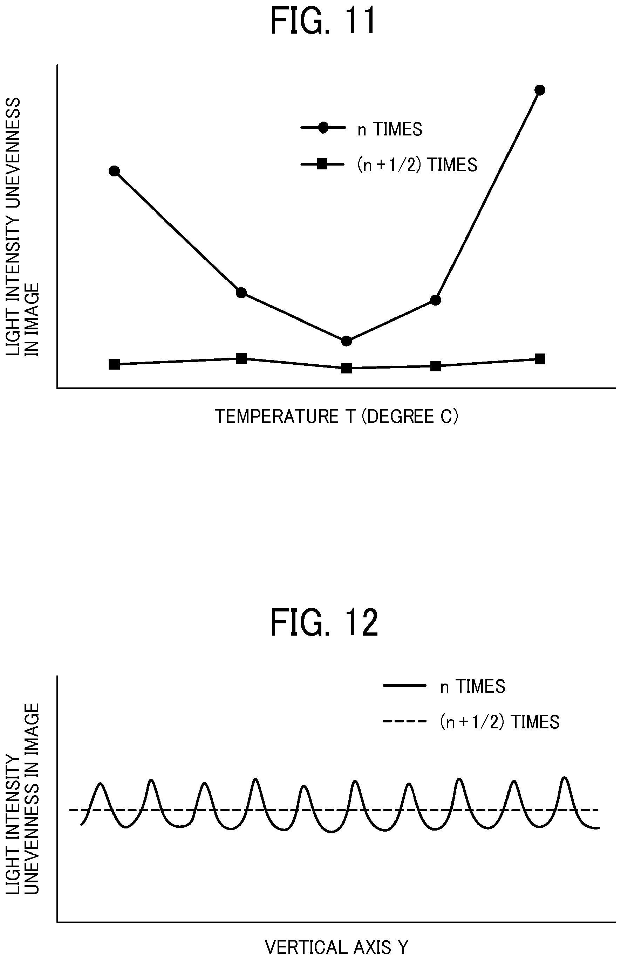

Further, for addressing the ambient temperature change, in order to maintain the uniformity of the light scanning speed of the optical deflection mirror 1, it is necessary to satisfy the following relationship, assuming that "n" is an integer, as illustrated in Fig. 11.

$$n < (f0 + f\Delta)/fv < n+1 \qquad \text{(Equation 2)}$$

Namely, adjustments are performed as follows. Based on the used temperature range $\Delta T$ which is a range of temperatures in which the two-dimensional image display device 30 and the optical deflection device 20 will be used, a driving frequency for maintaining the relationship between the mechanical resonance and the driving frequency which satisfies the Equation 2 is stored in the memory of the mirror controller 22, and the mirror driving unit 21 is controlled therewith.

This enables continuously maintaining a linear light scanning speed uniformity over a wider temperature range, at the same set driving frequency, as illustrated in Fig. 12, without performing complicated adjustment every time the temperature has changed. Further, as illustrated in Fig. 12, it is possible to eliminate brightness unevenness and image pattern distortions, which are prone to be induced in images in the vertical direction. Further, it is possible to project images with higher quality regardless of the environment, without performing complicated signal processing such as driving control based on temperature table data, using external temperature detection means, and the like.

This enables alleviating the problems of image amplitude deviations, deviations between mirror scanning timing and light-emission synchronization timing, and image fluctuations, due to waving of the light scanning speed, in the two-dimensional image display device 30.

Further, by combining the mechanism for adjusting the driving frequency with the mechanism for adjusting the values of the voltages to the respective meander-shaped beam portions 4, it is possible to perform light scanning with higher quality and lower temperature dependency.

Further, even when slight unevenness is induced due to working errors generated in the fabrication processing for the optical deflection device and the positions of the piezoelectric members, it is possible to compensate for these errors through the mechanism for adjusting the driving frequency. Therefore, it is possible to improve the uniformity in the sub-scanning direction and, concurrently, it is possible to compensate for errors resulted from working, thereby increasing the yield in the fabrication processing.

Hereinafter, there will be described an example of control of the optical deflection mirror 1 by the mirror controller 22 according to the present invention. More specifically, for horizontal scanning in the X direction along the horizontal axis, a sinusoidal voltage with a frequency of about 20 kHz, which is a higher frequency by several tens of Hz than the resonance frequency, is applied, so that the mirror 2 is rotated at about 20 kHz through torsions of the torsion bars 6a and 6b. Regarding the angle of rotation of the mirror 2, the optical deflection mirror 1 is operated such that the mirror 2 can rotate by about $\pm10$ degrees.

On the other hand, by driving the longitudinal beam portions 4a and the longitudinal beam portions 4b, the movable frame 3b is rotated in the Y-axis direction and, along therewith, the mirror 2 is also rotated in the vertical direction.

More specifically, voltages with a sawtooth waveform are applied to every other piezoelectric member, out of the piezoelectric members 5a and 5b provided independently of the respective beam portions which are meandered, in the longitudinal beam portions 4a and the longitudinal beam portions 4b. The voltage application pattern is such that the sawtooth waves to the longitudinal beam portions 4a and the longitudinal beam portions 4b are deviated in phase from each other, for adjusting their maximum voltage values. In this case, the adjustment is set in such a way as to satisfy the relationship of f0/fv=n, n+1/2. The raster scanning through such non-resonance driving is operated in such a way as to provide rotations of about $\pm4$ degrees, with sawtooth waves with a frequency of about 60 Hz.

Two-dimensional images were displayed, using two-axis scanning with the optical deflection mirror 1. Further, the driving conditions were set to satisfy the relationships of f0/fv=n and f0/fv=n+1/2, and image light-intensity unevenness was determined within the temperature range of about -25 degrees C to 75 degrees C, for the respective driving conditions.

As a result thereof, as illustrated in Fig. 10, under the condition where the relative relationship between the resonance and the driving frequency was "n" times, more image quality degradations were observed as the temperature was deviated from the room temperature.

With light scanning satisfying the relationship of Equation 2, the image quality degradation due to the temperature was reduced to about 1/10 or less.

The waving in the actual images was as illustrated in Fig. 11. With the light scanning satisfying Equation 2, the light scanning speed is made constant, which enables providing two-dimensional images having image quality with excellent temperature stability.

There has been illustrated an example where one or more light sources 33 are mainly used, and laser light having been subjected to two-dimensional light scanning through the optical deflection mirror 1 is projected onto the projection surface S such as a screen, as described above, but the present invention is not limited thereto.

For example, the present invention can be applied to a head-up display device for a vehicle or the like, which employs a diffusion plate as a screen and forms virtual images using a semi-transparent plate or the like. Further, there has been described a structure capable of two-axis scanning as the optical deflection mirror 1, but the present invention can be also applied to an optical deflection device for one-dimensional light scanning through only non-resonance raster scanning.

As described above, the present invention is not limited to only the structure according to the aforementioned embodiment, such that the present invention may be implemented in various other ways to have other designs.

As described above, with the optical deflection mirror that is used in a method of the present invention, it is possible to ensure a uniform light scanning speed regardless of the ambient environmental temperature during light scanning through non-resonance driving, thereby providing images with higher quality and with reduced brightness unevenness and reduced image distortions, without involving additional sensor mechanisms or complicated signal processing.

Numerous additional modifications and variations are possible in light of the above teachings. It is therefore to be understood that within the scope of the appended claims, the disclosure of the present invention may be practiced otherwise than as specifically described herein. For example, elements and/or features of different illustrative embodiments may be combined with each other and/or substituted for each other within the scope of the appended claims.

**Claims**

1. A method of configuring an optical deflection device (20), the optical deflection device (20) comprising:

    a mirror (2) having a reflective surface;
    a pair of meander-shaped beam portions (4) configured to rotatably support the mirror (2), each meander-shaped beam portion (4) having a plurality of beam portions (4a, 4b) alternately connected at folding-back sections to form a meander shape;
a plurality of piezoelectric members (5a, 5b) provided on the respective beam portions (4a, 4b) and applied with voltage waveforms to deform the respective beam portions (4a, 4b), wherein accumulated deformation of the respective beam portions (4a, 4b) causes mirror (2) to rotate; and
a voltage controller (22) that applies a periodic voltage waveform to the respective piezoelectric members (5a, 5b),
**characterized in that** the method comprises:

selecting a temperature range that is a range of temperatures in which the optical deflection device (20) will be used; and setting the driving frequency of the voltage waveform based on an equation of the form $n < (f_0+\Delta f)/f_v < n+1$ for all values of $\Delta f$, wherein n is an integer, $f_v$ is the driving frequency of the voltage waveform, $\Delta f$ is the frequency shift of the mechanical resonance frequency modes due to temperature change across the selected temperature range, and $f_0$ is the mechanical resonance frequency ($f_0$) of the system including the mirror (2), the meander-shaped beam portions (4) and the piezoelectric members (5a, 5b).

2. The method of configuring an optical deflection device (2) according to claim 1, wherein the shift of the resonance frequency ($\Delta f$) due to temperature change is linear.

3. The method of configuring an optical deflection device (2) according to Claim 2, wherein the voltage controller (22) applies two different voltage waveforms to the piezoelectric member (5a, 5b) of alternate beam portions (4a, 4b), and wherein the two waveforms are deviated in phase from each other.

4. The method of configuring an optical deflection device (2) according to Claim 3, wherein the voltage controller (22) has the respective driving frequencies ($f_v$) of the two types of the applied voltage waveforms stored in a memory, and applies the voltage waveforms to the respective piezoelectric members (5a, 5b) based on the stored values of the respective driving frequencies ($f_v$).

5. The method of configuring an optical deflection device (2) according to Claim 4, wherein the voltage controller (22) stores the resonance frequency ($f_0$) of the optical polarization device (2) in addition to the respective driving frequencies ($f_v$) of the two types of the voltage waveforms, and applies a voltage to each of the piezoelectric members (5a, 5b), based on a relative value of each of the driving frequencies ($f_v$) of the two types of the voltage waveforms with respect to the resonance frequency ($f_0$).

6. The method of configuring an optical deflection device (2) according to Claim 5, wherein the voltage controller (22) applies voltage to each of the piezoelectric members (5a, 5b), so as to satisfy a driving condition which prevents the ratio between the resonance frequency ($f_0$) and each of the driving frequencies ($f_v$) from being an integer multiple.

7. The method of configuring an optical deflection device (2) according to Claim 6, wherein the voltage controller (22) applies a different maximum value of the voltage waveform to each of the piezoelectric members (5a, 5b) .

8. A method of fabricating an image projection device comprising an optical deflection device (2), the method comprising the steps of:

configuring an optical deflection device according to the method of any one of Claims 1 to 7; and incorporating the optical deflection device into the image projection device.

9. The method of configuring an optical deflection device (1) according to claim 1, wherein

the mirror (2) is configured to perform two-dimensional light scanning while rotating about two axes orthogonal to each other within the same plane orthogonal to an optical axis, and each of the voltage waveforms is applied to the respective piezoelectric members (5a, 5b) to cause the mirror (2) to rotate about at least one axis of the two axes.

**Patentansprüche**

1. Verfahren zum Konfigurieren einer optischen Ablenkungsvorrichtung (20), wobei die optische Ablenkungsvorrichtung (20) umfasst:

einen Spiegel (2) mit einer reflektierenden Oberfläche;
ein Paar mäanderförmiger Balkenabschnitte (4), die dazu konfiguriert sind, den Spiegel (2) drehbar zu tragen, wobei jeder mäanderförmige Balkenabschnitt (4) eine Mehrzahl von Balkenabschnitten (4a, 4b) aufweist, die abwechselnd an zurückfaltenden Bereichen verbunden sind, um eine Mäanderform auszubilden;

eine Mehrzahl von piezoelektrischen Elementen (5a, 5b), die an den jeweiligen Balkenabschnitten (4a, 4b) bereitgestellt sind und mit Spannungswellenformen angewandt werden, um die jeweiligen Balkenabschnitte (4a, 4b) zu verformen, wobei eine akkumulierte Verformung der jeweiligen Balkenabschnitte (4a, 4b) eine Drehung des Spiegels (2) bewirkt; und eine Spannungssteuerrichtung (22), die eine periodische Spannungswellenform an die jeweiligen piezoelektrischen Elemente (5a, 5b) anwendet,

**dadurch gekennzeichnet, dass** das Verfahren umfasst:

Auswählen eines Temperaturbereichs, der ein Bereich von Temperaturen ist, in dem die optische Ablenkungsvorrichtung (20) verwendet wird; und
Einstellen der Antriebsfrequenz der Spannungswellenform auf Grundlage einer Gleichung der Form n < (f0+ Δf)/fv < n+1 für alle Werte von Δf,
wobei n eine ganze Zahl ist, fv die Antriebsfrequenz der Spannungswellenform ist, Δf die Frequenzverschiebung der mechanischen Resonanzfrequenzmoden aufgrund einer Temperaturänderung über den ausgewählten Temperaturbereich ist und f0 die mechanische Resonanzfrequenz (f0) des Systems ist, das den Spiegel (2), die mäanderförmigen Balkenabschnitte (4) und die piezoelektrischen Elemente (5a, 5b) beinhaltet.

2. Verfahren zum Konfigurieren einer optischen Ablenkungsvorrichtung (2) nach Anspruch 1, wobei die Verschiebung der Resonanzfrequenz (Δf) aufgrund einer Temperaturänderung linear ist.

3. Verfahren zum Konfigurieren einer optischen Ablenkungsvorrichtung (2) nach Anspruch 2, wobei die Spannungssteuervorrichtung (22) zwei unterschiedliche Spannungswellenformen an das piezoelektrische Element (5a, 5b) von abwechselnden Balkenabschnitten (4a, 4b) anwendet, und wobei die zwei Wellenformen in Phasen voneinander abweichen.

4. Verfahren zum Konfigurieren einer optischen Ablenkungsvorrichtung (2) nach Anspruch 3, wobei die Spannungssteuervorrichtung (22) die jeweiligen Antriebsfrequenzen (fv) der zwei Typen der angewandten Spannungswellenformen in einem Speicher gespeichert hat und die Spannungswellenformen auf Grundlage der gespeicherten Werte der jeweiligen Antriebsfrequenzen (fv) an die jeweiligen piezoelektrischen Elemente (5a, 5b) anwendet.

5. Verfahren zum Konfigurieren einer optischen Ablenkungsvorrichtung (2) nach Anspruch 4, wobei die Spannungssteuervorrichtung (22) die Resonanzfrequenz (f0) der optischen Polarisationsvorrichtung (2) zusätzlich zu den jeweiligen Antriebsfrequenzen (fv) der zwei Typen der Spannungswellenformen speichert und auf jedes der piezoelektrischen Elemente (5a, 5b) eine Spannung anwendet, die auf einem relativen Wert jeder der Antriebsfrequenzen (fv) der zwei Typen der Spannungswellenformen in Bezug auf die Resonanzfrequenz (f0) basiert.

6. Verfahren zum Konfigurieren einer optischen Ablenkungsvorrichtung (2) nach Anspruch 5, wobei die Spannungssteuervorrichtung (22) eine Spannung auf jedes der piezoelektrischen Elemente (5a, 5b) anwendet, um eine Antriebsbedingung zu erfüllen, die verhindert, dass das Verhältnis zwischen der Resonanzfrequenz (f0) und jeder der Antriebsfrequenzen (fv) ein ganzzahliges Vielfaches ist.

7. Verfahren zum Konfigurieren einer optischen Ablenkungsvorrichtung (2) nach Anspruch 6, wobei die Spannungssteuervorrichtung (22) einen unterschiedlichen Maximalwert der Spannungswellenform auf jedes der piezoelektrischen Elemente (5a, 5b) anwendet.

8. Verfahren zum Fertigen einer Bildprojektionsvorrichtung, die eine optische Ablenkungsvorrichtung (2) umfasst, wobei das Verfahren die Schritte umfasst:

Konfigurieren einer optischen Ablenkungsvorrichtung gemäß dem Verfahren nach einem der Ansprüche 1 bis 7; und
Einbauen der optischen Ablenkungsvorrichtung in die Bildprojektionsvorrichtung.

9. Verfahren zum Konfigurieren einer optischen Ablenkungsvorrichtung (1) nach Anspruch 1, wobei

der Spiegel (2) dazu konfiguriert ist, eine zweidimensionale Lichtabtastung durchzuführen, während er sich um zwei Achsen dreht, die in der gleichen Ebene orthogonal zueinander sind, die orthogonal zu einer optischen Achse ist, und jede der Spannungswellenformen an die jeweiligen piezoelektrischen Elemente (5a, 5b) angewendet wird, um zu bewirken, dass sich der Spiegel (2) um wenigstens eine Achse der zwei Achsen dreht.

**Revendications**

1. Procédé de configuration d'un dispositif de déviation optique (20), le dispositif de déviation optique (20) comprenant :

un miroir (2) ayant une surface réfléchissante ;
une paire de parties de poutre en forme de méandre (4) configurées pour supporter de manière rotative le miroir (2), chaque partie de poutre en forme de méandre (4) ayant une pluralité de parties de poutre (4a, 4b) connectées alternativement à des sections de repli pour former une forme de méandre ;
une pluralité d'éléments piézoélectriques (5a, 5b) prévus sur les parties de poutre respectives (4a, 4b) et auxquels sont appliquées des formes d'onde de tension pour déformer les parties de poutre respectives (4a, 4b), la déformation accumulée des parties de poutre respectives (4a, 4b) provoquant la rotation du miroir (2) ; et
un contrôleur de tension (22) qui applique une forme d'onde de tension périodique aux éléments piézoélectriques respectifs (5a, 5b), **caractérisé en ce que** le procédé comprend :

la sélection d'une plage de température qui est une plage de températures dans laquelle le dispositif de déviation optique (20) sera utilisé ; et
le réglage de la fréquence d'entraînement de la forme d'onde de tension sur la base d'une équation de la forme n < (f0 + Δf)/fv < n+1 pour toutes les valeurs de Δf,
dans lequel n est un nombre entier, fv est la fréquence d'entraînement de la forme d'onde de tension, Δf est le décalage de fréquence des modes de fréquence de résonance mécanique dû au changement de température dans la plage de température sélectionnée, et f0 est la fréquence de résonance mécanique (f0) du système comprenant le miroir (2), les parties de poutre en forme de méandre (4) et les éléments piézoélectriques (5a, 5b).

2. Procédé de configuration d'un dispositif de déviation optique (2) selon la revendication 1, dans lequel le décalage de la fréquence de résonance (Δf) dû au changement de température est linéaire.

3. Procédé de configuration d'un dispositif de déviation optique (2) selon la revendication 2, dans lequel le contrôleur de tension (22) applique deux formes d'onde de tension différentes à l'élément piézoélectrique (5a, 5b) de parties de poutre alternées (4a, 4b), et dans lequel les deux formes d'onde sont déviées en phase l'une par rapport à l'autre.

4. Procédé de configuration d'un dispositif de déviation optique (2) selon la revendication 3, dans lequel

le contrôleur de tension (22) a les fréquences d'entraînement respectives (fv) des deux types de formes d'onde de tension appliquées stockées dans une mémoire, et applique les formes d'onde de tension aux éléments piézoélectriques respectifs (5a, 5b) sur la base des valeurs stockées des fréquences d'entraînement respectives (fv).

5. Procédé de configuration d'un dispositif de déviation optique (2) selon la revendication 4, dans lequel le contrôleur de tension (22) stocke la fréquence de résonance (f0) du dispositif de polarisation optique (2) en plus des fréquences d'entraînement respectives (fv) des deux types de formes d'onde de tension, et applique une tension à chacun des éléments piézoélectriques (5a, 5b), sur la base d'une valeur relative de chacune des fréquences d'entraînement (fv) des deux types de formes d'onde de tension par rapport à la fréquence de résonance (f0).

6. Procédé de configuration d'un dispositif de déviation optique (2) selon la revendication 5, dans lequel le contrôleur de tension (22) applique une tension à chacun des éléments piézoélectriques (5a, 5b), de manière à satisfaire une condition d'entraînement qui empêche le rapport entre la fréquence de résonance (f0) et chacune des fréquences d'entraînement (fv) d'être un multiple entier.

7. Procédé de configuration d'un dispositif de déviation optique (2) selon la revendication 6, dans lequel le contrôleur de tension (22) applique une valeur maximale différente de la forme d'onde de tension à chacun des éléments piézoélectriques (5a, 5b).

8. Procédé de fabrication d'un dispositif de projection d'image comprenant un dispositif de déviation optique (2), le procédé comprenant les étapes consistant à :

configurer un dispositif de déviation optique selon le procédé de l'une quelconque des revendications 1 à 7 ; et
incorporer le dispositif de déviation optique dans le dispositif de projection d'image.

9. Procédé de configuration d'un dispositif de déviation optique (1) selon la revendication 1, dans lequel

le miroir (2) est configuré pour effectuer un balayage de lumière bidimensionnel tout en tournant autour de deux axes orthogonaux l'un à l'autre dans le même plan orthogonal à un axe optique, et
chacune des formes d'onde de tension est appliquée aux éléments piézoélectriques respectifs (5a, 5b) pour amener le miroir (2) à tourner autour d'au moins un axe des deux axes.

# FIG. 1

EP 2 924 485 B1

# FIG. 2

EP 2 924 485 B1

# FIG. 3A

RESONANCE
DRIVING

Y

S

NON-RESONANCE
DRIVING

X

# FIG. 3B

WAVING OF LIGHT
SCANNING

UNIFORM LIGHT
SCANNING

LIGHT INTENSITY

VERTICAL AXIS Y

# FIG. 4A

# FIG. 4B

# FIG. 4C

# FIG. 4D

# FIG. 5A

IMAGE DISPLAY
RANGE

SCANNING SPEED

TIME

# FIG. 5B

SCANNING SPEED

TIME

# FIG. 6

DEFLECTION ANGLE

$f_0$          FREQUENCY          $f_1$

# FIG. 7

# FIG. 8

# FIG. 9

RESONANCE FREQUENCY

a

TEMPERATURE T

# FIG. 10

DEGREE OF INTERFERENCE
BETWEEN RESONANCE AND
RESONANCE DRIVING

$(f_0 - \Delta f)/f_V$

$(f_0 + \Delta f)/f_V$

$f_0 - f_V$

n

n+1/2

n+1

RESONANCE-FREQUENCY/DRIVING-FREQUENCY

# FIG. 11

LIGHT INTENSITY UNEVENNESS IN IMAGE

● n TIMES
■ (n+1/2) TIMES

TEMPERATURE T (DEGREE C)

# FIG. 12

LIGHT INTENSITY UNEVENNESS IN IMAGE

—— n TIMES
---- (n+1/2) TIMES

VERTICAL AXIS Y

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011107505 A
- EP 2495600 A1
- EP 2645148 A1
- EP 2848978 A1